# EUROPEAN PATENT SPECIFICATION

(11) **EP 2 729 819 B1**
(45) Date of publication and mention of the grant of the patent: **19.08.2015**
(21) Application number: 12751602.9
(22) Date of filing: 04.07.2012
(51) Int. Cl.: G01R 19/15, G01R 33/032, G01R 15/24, G01R 19/00

(54) **CURRENT SENSOR**
STROMSENSOR
CAPTEUR DE COURANT

(30) Priority: 05.07.2011 JP 2011149012
(43) Date of publication of application: 14.05.2014
(73) Proprietor: TOYOTA JIDOSHA KABUSHIKI KAISHA, Aichi-ken, 471-8571 (JP)
(72) Inventor: SEO, Yusuke, Aichi-ken 471-8571 (JP); KIKUCHI, Naoto, Aichi-ken 480-1192 (JP); TAKAGI, Kenichi, Aichi-ken 480-1192 (JP)
(74) Representative: Winter, Brandl, Fürniss, Hübner, Röss, Kaiser, Polte - Partnerschaft mbB
(86) International application number: PCT/IB2012/001320
(87) International publication number: WO 2013/005096

(56) References cited:
- US-A- 4 612 500
- US-A- 4 947 107
- US-A- 5 663 652

## Description

The invention relates to a current sensor and, more particularly, to a current sensor that detects a current through light with the use of a magnetic thin film.

As for a current measuring device using light, there is suggested a current measuring device (for example, see Japanese Patent Application Publication No. 7-174790 (JP 7-174790 A)). In this current measuring device, light emitted from a light source is converted by a polarizer into linearly polarized light, the polarization direction of the linearly polarized light is rotated by a magneto-optical element owing to the magneto-optical effect, the linearly polarized light having any polarization direction is split by an analyzer into two orthogonal polarization components and then emitted in different directions, and then the intensities of light beams, split into two polarization components, are respectively separately converted by two photoreceptors into electric signals.

In addition, as for a current sensor that detects the value of current flowing through a bus bar, there has been disclosed a technique that a boss is provided on a core holder that holds a magnetic core, the bus bar has a hole that is fitted to the boss and then the magnetic core is fixedly positioned on the bus bar (for example, see Japanese Patent Application Publication No. 2008-275566 (JP 2008-275566 A)).

US 5 663 652 discloses an apparatus and method for measuring the current distribution in an integrated circuit with high time resolution. The apparatus incorporates a magneto-optic film, a linearly polarized light beam and a means for measuring the magneto-optic polarization rotation of a light beam and circuitry for synchronizing test pulses in an integrated circuit.

Current detection through light with the use of a magnetic thin film, which is utilized to read or write information from or to a magnetic disk or a magneto-optical disk, has such a characteristic that the sensitivity of current detection varies depending on the direction in which a magnetic field is applied to the magnetic film. That is, when the mounting position of a magnetic thin film that detects a magnetic field deviates at the time of assembling a current sensor, the direction in which a magnetic field is applied to the magnetic thin film also deviates, so the degree of ease of magnetization of the magnetic thin film varies. Therefore, there are differences among the characteristics of magnetic thin films. For example, some magnetic thin films are magnetized by a smaller magnetic field, and others are not magnetized unless a large magnetic field is applied. The differences among the characteristics of the magnetic thin films directly appear as the characteristics of current sensors, so the characteristics of current sensors may deviate from one another.

The invention provides a current sensor that suppresses variations in the characteristic of the sensor to make it possible to improve the accuracy of detecting a current.

The invention provides a current sensor as defined in claim 1, or any one of the dependent claims.

An aspect of the invention relates to a current sensor for detecting a current that flows through a bus bar. The current sensor includes: a base that is attached to the bus bar; a magnetic thin film that is mounted on the base; a luminescent device that irradiates light to the magnetic thin film; a photoreceptor device that detects light that is irradiated from the luminescent device to the magnetic thin film and that is reflected from the magnetic thin film; a computing device that converts an optical signal, detected by the photoreceptor device, into the current that flows through the bus bar; and a rotation restricting portion that restricts relative rotation of the magnetic thin film with respect to the bus bar.

In the current sensor, the rotation restricting portion includes a mounting position restricting portion that restricts a mounting position of the magnetic thin film on the base and a base fixing portion that restricts relative rotation of the base with respect to the bus bar.

In the current sensor, the mounting position restricting portion may have a wall portion that surrounds the magnetic thin film.

In the current sensor, the base fixing portion may have a reference pin that protrudes from the base toward the bus bar and that is inserted in a reference hole , formed in the bus bar.

The current sensor may further include a restricting member that restricts an angle of a passage of incident light, irradiated to the magnetic thin film, with respect to a surface of the magnetic thin film and an angle of a passage of reflected light, reflected from the magnetic thin film, with respect to the surface of the magnetic thin film.

According to the aspect of the invention, the current sensor is able to suppress variations in the characteristic of the sensor to thereby make it possible to improve the accuracy of detecting a current.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a cross-sectional view that shows the configuration of a current sensor according to an embodiment of the present invention;
FIG. 2 is a plan view of the current sensor;
FIG. 3 is a cross-sectional view of the current sensor, taken along the line III-III in FIG. 2;
FIG. 4 is an exploded perspective view of the current sensor;
FIG. 5 is a schematic view that shows the configuration of an optical system used in the current sensor;
FIG. 6 is a schematic plan view that shows a state where a magnetic thin film is positioned; and
FIG. 7 is a schematic plan view that shows a state where there is a misalignment of a magnetic thin film.

### DETAILED DESCRIPTION OF EMBODIMENTS

Hereinafter, an embodiment of the invention will be described with reference to the accompanying drawings. Note that, in the drawings, like reference numerals denote the same or corresponding components, and the description thereof is not repeated.

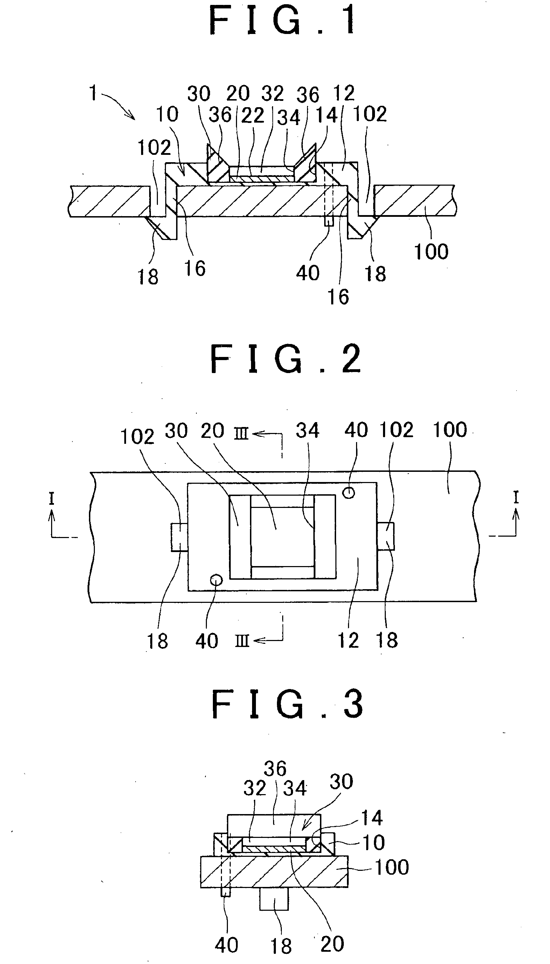

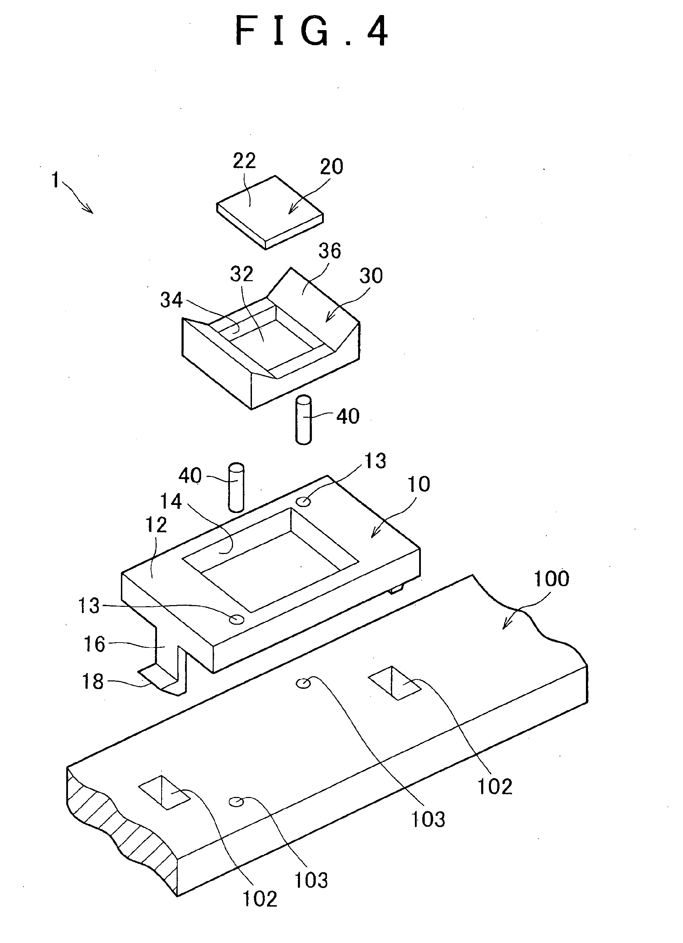

FIG. 1 is a cross-sectional view that shows the configuration of a current sensor 1 according to the present embodiment. FIG. 2 is a plan view of the current sensor 1. FIG. 3 is a cross-sectional view of the current sensor 1, taken along the line III-III in FIG. 2. FIG. 4 is an exploded perspective view of the current sensor 1. The configuration of the current sensor 1 according to the present embodiment will be described with reference to FIG. 1 to FIG. 4.

The current sensor 1 is used to detect a current that flows through a long slender rod-shaped electrically conductive bus bar 100. The current sensor 1 includes a magnetic thin film 20. The magnetic thin film 20 is made of a material having a magnetocrystalline anisotropy. The magnetic thin film 20 is mounted on a base 10.

The base 10 has a planar (plate-like) body portion 12 and a pair of leg portions 16. The magnetic thin film 20 is mounted on the body portion 12. The pair of leg portions 16 protrude from one of the faces of the body portion 12. The body portion 12 has a planar rectangular recess 14 at the other face that is opposite to the face from which the leg portions 16 protrude. The recess 14 is formed such that part of the body portion 12 is recessed. Each of the leg portions 16 has a pawl 18 at its distal end. The base 10 is, for example, made of a resin material.

The bus bar 100 has through holes 102 that extend (or penetrate) through the bus bar 100 in the thickness direction. The leg portions 16 are respectively inserted through the through holes 102, and the pawls 18 at the lower ends of the leg portions 16 extending through the through holes 102 are engaged with the opposite face of the bus bar 100. By so doing, the base 10 is fixed to the bus bar 100. Note that it is not limited to the configuration that the base 10 is fixed to the bus bar 100 by the engagement of the pawls 18 with the through holes 102; for example, the base 10 may be fixedly screwed to the bus bar 100.

The bus bar 100 has a pair of through holes 103 that serve as reference holes. The through holes 103 extend (or penetrate) through the bus bar 100 in the thickness direction. The body portion 12 of the base 10 has a pair of through holes 13 that extend (or penetrate) through the body portion 12 in the thickness direction. The through holes 13 and 103 are formed such that the through holes 13 and the through holes 103 respectively overlap each other in a state where the leg portions 16 of the base 10 are fitted to the through holes 102 of the bus bar 100 to place the body portion 12 on the surface of the bus bar 100. Pins 40 that serve as reference pins are arranged so as to extend through the through holes 13 and 103 in a state where the base 10 is assembled to the bus bar 100.

An accommodation member 30 is fitted to the recess 14 formed in the body portion 12 of the base 10. The accommodation member 30 accommodates the magnetic thin film 20. The magnetic thin film 20 is mounted on the base 10 via the accommodation member 30. The accommodation member 30 has an accommodation hole that is used to accommodate the magnetic thin film 20. The accommodation hole is formed so that the back face of the magnetic thin film 20 contacts with the bottom face 32 of the accommodation hole and the lateral end face of the magnetic thin film 20 faces the inner wall surface 34 of the accommodation hole. When the magnetic thin film 20 has a square planar shape, the planar shape of the accommodation hole is also a square shape. The dimensions (other than the thickness) of the accommodation hole are respectively equal to the longitudinal and lateral lengths across the magnetic thin film 20 or (as long as the magnetic thin film 20 does not lose the function as a magnetic thin film) are respectively slightly smaller than the longitudinal and lateral lengths across the magnetic thin film 20 so that the magnetic thin film 20 is fitted to the accommodation hole. Therefore, a misalignment of the magnetic thin film 20, accommodated inside the accommodation hole, with respect to the accommodation member 30 is suppressed.

The shape of the accommodation member 30 is rectangular in plan view. The square planar-shaped accommodation hole is formed at the center of the accommodation member 30. At both long sides of the accommodation member 30, the thickness of the accommodation member 30 is gradually increased from the accommodation hole toward the edge of the accommodation member (tapered portions). The tapered portions function as restricting members 36. The restricting members 36 restrict the angle of the passage of incident light, irradiated toward the surface 22 of the magnetic thin film 20 accommodated in the accommodation hole, with respect to the surface 22 of the magnetic thin film 20, and the angle of the passage of reflected light, that the incident light is reflected from the surface 22 of the magnetic thin film 20, with respect to the surface 22 of the magnetic thin film 20.

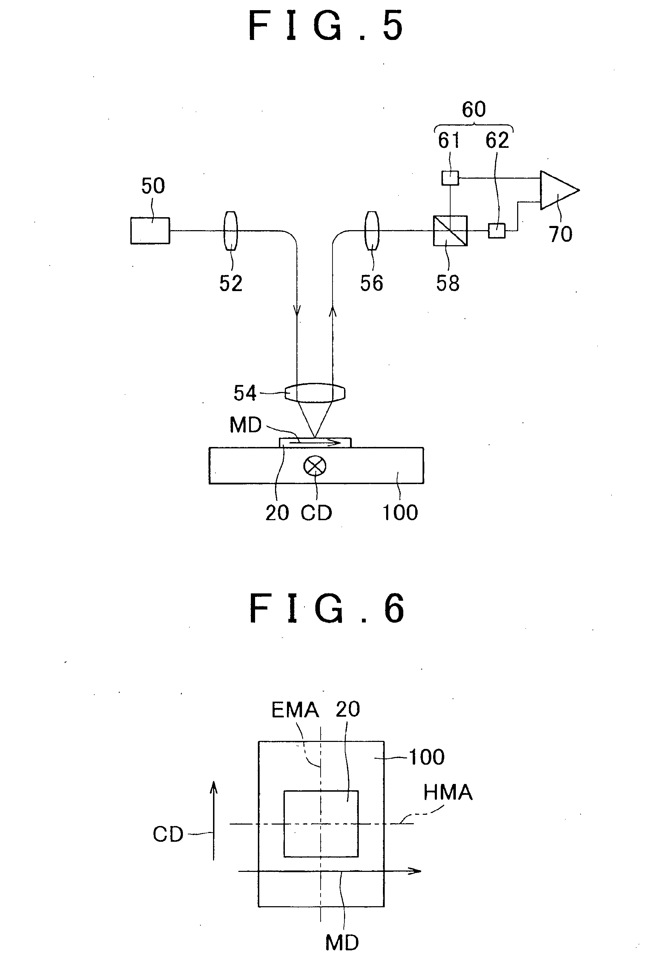

FIG. 5 is a schematic view that shows the configuration of an optical system used in the current sensor 1. Note that FIG. 5 and FIG. 6 and FIG. 7 (described later) only show the bus bar 100 for transferring output current and the magnetic thin film 20 mounted on the bus bar 100 within the configuration of the current sensor 1, described with reference to FIG. 1 to FIG. 4, for the sake of simplification. The current sensor 1 detects a current flowing through the bus bar 100 with the use of the magnetic thin film 20 fixedly attached to the bus bar 100.

As shown in FIG. 5, light generated by a luminescent device 50 is irradiated toward the magnetic thin film 20 via a polarizing prism 52 and a condenser lens 54. Reflected light reflected from the surface of the magnetic thin film 20 enters a beam splitter 58 via the condenser lens 54 and a quarter wave length plate 56, split by the beam splitter 58 into two light beams, and then the two light beams respectively enter photodiodes 61 and 62. The photodiodes 61 and 62 are included in a photoreceptor device 60. The photoreceptor device 60 detects light that is irradiated from the luminescent device 50 toward the magnetic thin film 20 and that is reflected from the magnetic thin film 20. The photodiodes 61 and 62 respectively detect the intensities of light beams, which respectively enter the photodiodes 61 and 62, and inputs the detected intensities to a differential amplifier 70. The differential amplifier 70 is a computing device that converts optical signals, respectively detected by the photodiodes 61 and 62, into a current that flows through the bus bar 100.

When no current flows through the bus bar 100, the intensities of light beams that respectively enter the two photodiodes 61 and 62 are equal to each other, so the output of the differential amplifier 70 that is input the outputs of the photodiodes 61 and 62 is zero. On the other hand, when current flows through the bus bar 100, a magnetic field occurs around the bus bar 100, and the magnetic field is applied to the magnetic thin film 20. In FIG. 5, the direction CD in which current flows through the bus bar 100 and the direction MD in which the magnetic thin film 20 is magnetized by the magnetic field generated by the current are shown. The magnetic moment of the magnetic thin film 20 rotates to change the intensities of light beams that are split by the beam splitter 58 and that respectively enter the two photodiodes 61 and 62, causing a differential between the intensities of light beams that enter the photodiodes 61 and 62. Thus, the output appears from the differential amplifier 70.

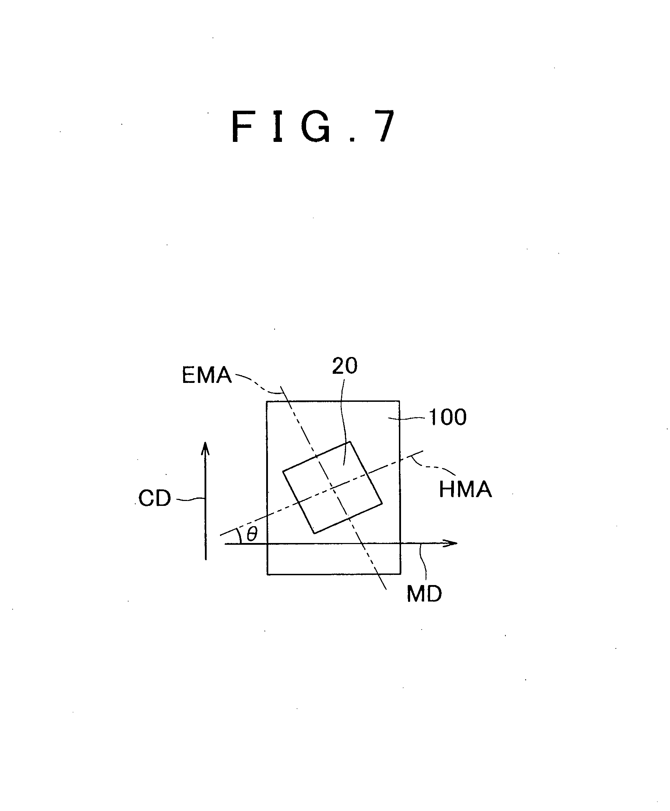

The influence of a misalignment of the magnetic thin film 20 at the time when the thus configured current sensor 1 is used to detect a current flowing through the bus bar 100 will be described. FIG. 6 is a schematic plan view that shows the current sensor 1 in a state where the magnetic thin film 20 is positioned. FIG. 7 is a schematic plan view that shows the current sensor 1 in a state where there is a misalignment of the magnetic thin film 20. In FIG. 6 and FIG. 7, current flows through the bus bar 100 from the lower side toward the upper side in the drawing as indicated by the arrow CD, the direction of a magnetic field that is generated by that current at the position of the magnetic thin film 20 is indicated by the arrow MD.

Owing to the magnetocrystalline anisotropy of the material of the magnetic thin film 20, the magnetic thin film 20 has a crystal orientation that is easy to be magnetized (axis of easy magnetization) and a crystal orientation that is hard to be magnetized (axis of hard magnetization). In FIG. 6 and FIG. 7, the axis of easy magnetization is indicated by the alternate long and two short dashes line EMA, and the axis of hard magnetization is indicated by the alternate long and two short dashes line HMA.

The state where the magnetic thin film 20 is positioned, shown in FIG. 6, is a state where the relative position of the magnetic thin film 20 with respect to the bus bar 100 is set such that the axis of easy magnetization EMA is aligned in the direction CD of current that flows through the bus bar 100 and the axis of hard magnetization HMA is aligned in the direction MD of the magnetic field in the magnetic thin film 20. The positioned state shown in FIG. 6 is an ideal state where the magnetic field generated by current flowing through the bus bar 100 is applied to the magnetic thin film 20 in the direction along the axis of hard magnetization HMA.

On the other hand, the state where the magnetic thin film 20 is misaligned, shown in FIG. 7, is a state where the magnetic thin film 20 is relatively rotated by an angle θ with respect to the bus bar 100 and, as a result, the axis of easy magnetization EMA and the axis of hard magnetization HMA respectively deviate by the angle θ from the direction of the current and the direction MD of the magnetic field. In the misaligned state shown in FIG. 7, a magnetic field having a magnitude that is obtained by multiplying cosθ by the magnitude of the magnetic field applied to the magnetic thin film 20 in the ideal state shown in FIG. 6 is applied to the magnetic thin film 20 in the direction along the axis of hard magnetization HMA, and a magnetic field having a magnitude that is obtained by multiplying sinθ by the magnitude of the magnetic field applied to the magnetic thin film 20 in the ideal state is applied to the magnetic thin film 20 in the direction along the axis of easy magnetization EMA.

When there occurs a misalignment of the magnetic thin film 20, the magnetized direction of the magnetic thin film 20 is not aligned in one direction as compared with the ideal state, and the direction in which the magnetic field is applied to the magnetic thin film 20 varies. As a result, there occurs a characteristic difference in reflected light reflected from the surface 22 of the magnetic thin film 20, and the current sensor 1 has a different characteristic. Thus, the sensitivity of current detection decreases, and the measuring accuracy of the current sensor 1 decreases. Therefore, in order to improve the measuring accuracy of the current sensor 1, it is important to maintain the relative position of the magnetic thin film 20 with respect to the bus bar 100 in the ideal state shown in FIG. 6.

Therefore, the current sensor 1 according to the present embodiment includes a rotation restricting portion that is used to restrict relative rotation of the magnetic thin film 20 with respect to the bus bar 100. In the case of the present embodiment, the rotation restricting portion includes a mounting position restricting portion and a base fixing portion. The mounting position restricting portion restricts the mounting position of the magnetic thin film 20 on the base 10. The base fixing portion restricts relative rotation of the base 10 with respect to the bus bar 100.

The accommodation member 30 that accommodates the magnetic thin film 20, shown in FIG. 1 to FIG. 4, functions as the mounting position restricting portion. In a state where the magnetic thin film 20 is accommodated in the accommodation hole of the accommodation member 30, the magnetic thin film 20 is surrounded by the inner wall surface 34 of the accommodation hole. The inner wall surface 34 of the accommodation hole functions as a vertical wall portion that surrounds the magnetic thin film 20 accommodated inside the accommodation hole. The accommodation member 30 fitted in the recess 14 formed in the base 10 has the vertical wall portion that is used to fix the magnetic thin film 20. By so doing, a misalignment of the magnetic thin film 20 with respect to the base 10 is restricted.

The pins 40 shown in FIG. 1 to FIG. 4 function as the base fixing portion. The two pins 40 that serve as the reference pins are arranged through the through holes 13 and the through holes 103. The through holes 13 are formed in the base 10. The through holes 103 are formed in the bus bar 100 and serve as the reference holes. By so doing, a misalignment of the magnetic thin film 20 in the rotation direction with respect to the bus bar 100 is restricted.

Note that the reference pins may have any configuration as long as the reference pins protrude from the base 10 toward the bus bar 100 and are inserted through the through holes 103, and are not limited to the example in which the pins 40 that are separate members from the base 10 and the bus bar 100 are used. For example, the body portion 12 of the base 10 may partially have protrusions that are inserted through the through holes 103. In addition, for example, the through holes 103 may not extend through the bus bar 100 in the thickness direction or the reference pins may be inserted in closed-end holes recessed from the surface of the bus bar 100 at the side at which the body portion 12 of the base 10 is placed.

As described above, in the current sensor 1 according to the present embodiment, the magnetic thin film 20 is positioned with respect to the bus bar 100 to restrict relative rotation of the magnetic thin film 20 with respect to the bus bar 100. The mounting position of the magnetic thin film 20 on the bus bar 100 is restricted to form a structure that minimizes variations at the time of assembling the magnetic thin film 20 to the bus bar 100. By so doing, a misalignment of the magnetic thin film 20 with respect to the bus bar 100 may be suppressed, and variations in the characteristic of the current sensor 1 may be suppressed. Thus, it is possible to improve the accuracy of detecting current by the current sensor 1.

In addition, the current sensor 1 has the restricting member that restricts the angle of incident light to the magnetic thin film 20 and the angle of reflected light from the magnetic thin film 20. The incident and reflected angles of light with respect to the magnetic thin film 20 are defined as the angle made between the travelling direction of the incident light and the normal to the surface of the magnetic thin film 20 and the angle made between the travelling direction of the reflected light and the normal to the surface of the magnetic thin film 20. However, when the incident angle and the reflected angle are excessively large, it is concerned that the sensitivity of the current sensor 1 decreases. The restricting members 36 having a sufficient height with respect to the thickness of the magnetic thin film 20 are arranged around the magnetic thin film 20. By so doing, the range of the incident angle and the range of the reflected angle are appropriately limited to make it possible to optimize the sensitivity of the current sensor 1.

The embodiment of the invention is described above; however, the embodiment described above is illustrative and not restrictive in all respects. The scope of the invention is defined by the appended claims rather than the above description.

The current sensor 1 according to the embodiment of the invention may be particularly advantageously applied to an inverter current sensor that is used to detect a current flowing through an inverter used to drive an electric motor for an electric vehicle.

## Claims

1. A current sensor for detecting a current that flows through a bus bar including
a luminescent device (50) that irradiates light to a magnetic thin film (20),
a photoreceptor device (60) that detects light that is irradiated from the luminescent device (50) to the magnetic thin film (20) and that is reflected from the magnetic thin film (20), and
a differential amplifier (70) that converts an optical signal, detected by the photoreceptor device (60), into a current that flows through the bus bar,
**characterized by** comprising:
holes (102) that extend through the bus bar in the thickness direction;
a base (10) that is provided with the bus bar, the base (10) having a pair of leg portions (16) that have pawls (18) at their distal end and the leg portions (16) being respectively inserted through the through holes (102) such that the pawls (18) engage with the opposite face of the bus bar;
the magnetic thin film (20) being mounted on the base (10) via an accommodation member (30) functioning as a mounting position restriction portion;
and
a rotation restricting portion that restricts relative rotation of the magnetic thin film (20) with respect to the bus bar,
the rotation restricting portion including a mounting position restriction portion that restricts a mounting position of the magnetic thin film (20) on the base (10), and the rotation restricting portion including a base fixing portion that restricts relative rotation of the base (10) with respect to the bus bar.

2. The current sensor according to claim 1, wherein
the mounting position restriction portion has a wall portion that surrounds the magnetic thin film (20).

3. The current sensor according to claim 1, wherein
the mounting position restriction portion has an accommodation hole to which the magnetic thin film (20) is fitted.

4. The current sensor according to claim 1, 2 or 3, wherein
the base fixing portion has a reference pin that protrudes from the base (10) toward the bus bar and that is inserted in a reference hole formed in the bus bar.

5. The current sensor according to any one of claims 1 to 4, further comprising:
a restricting member (36) that restricts an angle of a passage of incident light, irradiated to the magnetic thin film (20), with respect to a surface of the magnetic thin film (20) and an angle of a passage of reflected light, reflected from the magnetic thin film (20), with respect to the surface of the magnetic thin film (20).

## Patentansprüche

1. Stromsensor für die Erfassung eines Stroms, der durch eine Sammelschiene fließt, enthaltend
eine lumineszierende Vorrichtung (50), die Licht auf einen magnetischen dünnen Film (20) strahlt,
eine Fotorezeptorvorrichtung (60), die Licht detektiert, das von der lumineszierenden Vorrichtung (50) auf den magnetischen dünnen Film (20) abgestrahlt ist und das von dem magnetischen dünnen Film (20) reflektiert ist, und
einen Differenzverstärker (70), der ein optisches Signal, das durch die Fotorezeptorvorrichtung (60) detektiert ist, in einen Strom umwandelt, der durch die Sammelschiene fließt,
**dadurch gekennzeichnet, dass** er aufweist:
Löcher (102), die sich durch die Sammelschiene in der Dickenrichtung erstrecken;
eine Basis (10), die mit der Sammelschiene versehen ist, wobei die Basis (10) ein Paar von Schenkelabschnitten (16) hat, die an ihrem distalen Ende Klauen (18) aufweisen, und wobei die Schenkelabschnitte (16) jeweils durch die Durchgangslöcher (102) derart eingeführt sind, dass die Klauen (18) mit der entgegengesetzten Fläche der Sammelschiene in Eingriff stehen;
wobei der magnetische dünne Film (20) an der Basis (10) über ein Unterbringungselement (30) montiert ist, das als ein Montageposition - Begrenzungsabschnitt fungiert;
einen Drehungs - Begrenzungsabschnitt, der eine relative Drehung des magnetischen dünnen Films (20) mit Bezug zu der Sammelschiene begrenzt,
wobei der Drehungs - Begrenzungsabschnitt einen Montagepositions - Beschränkungsabschnitt enthält, der eine Montageposition des magnetischen dünnen Films (20) an der Basis (10) beschränkt, und wobei der Drehungs-Begrenzungsabschnitt einen Basis - Fixierabschnitt enthält, der eine relative Drehung der Basis (10) mit Bezug zu der Sammelschiene beschränkt.

2. Stromsensor nach Anspruch 1, bei dem
der Montagepositions - Beschränkungsabschnitt einen Wandabschnitt aufweist, der den magnetischen dünnen Film (20) umgibt.

3. Stromsensor nach Anspruch 1, bei dem
der Montagepositions - Beschränkungsabschnitt ein Aufnahmeloch aufweist, an das der magnetische dünne Film (20) angepasst bzw. eingepasst ist.

4. Stromsensor nach Anspruch 1, 2 oder 3, bei dem
der Basis - Fixierabschnitt einen Referenzstift aufweist, der von der Basis (10) in Richtung zu der Sammelschiene vorsteht und der in ein Referenzloch eingeführt ist, das in der Sammelschiene ausgebildet ist.

5. Stromsensor nach einem beliebigen der Ansprüche 1 bis 4, der weiterhin aufweist:
ein Beschränkungselement (36), das einen Winkel eines Durchgangs von einfallendem Licht, das auf den magnetischen dünnen Film (20) eingestrahlt ist, mit Bezug zu einer Oberfläche des magnetischen dünnen Films (20), und einen Winkel eines Durchgangs von reflektiertem Licht, das von dem magnetischen dünnen Film (20) reflektiert ist, mit Bezug zu der Oberfläche des magnetischen dünnen Films (20) begrenzt.

## Revendications

1. Capteur de courant pour détecter un courant qui circule à travers une barre omnibus comprenant un dispositif luminescent (50) qui rayonne de la lumière sur un film magnétique fin (20),
un dispositif photorécepteur (60) qui détecte la lumière qui est rayonnée à partir du dispositif luminescent (50) jusqu'au film magnétique fin (20) et qui est réfléchie à partir du film magnétique fin (20), et
un amplificateur différentiel (70) qui convertit un signal optique, détecté par le dispositif photorécepteur (60), en un courant qui circule à travers la barre omnibus,
**caractérisé en ce qu'**il comprend :
des trous (102) qui s'étendent à travers la barre omnibus dans le sens de l'épaisseur ;
une base (10) qui est prévue avec la barre omnibus, la base (10) ayant une paire de parties de patte (16) qui ont des cliquets (18) au niveau de leur extrémité distale et les parties de patte (16) étant respectivement insérées à travers les trous débouchants (102) de sorte que les cliquets (18) se mettent en prise avec la face opposée de la barre omnibus ;
le film magnétique fin (20) étant monté sur la base (10) via un élément de logement (30) servant de partie de restriction de position de montage ; et
une partie de restriction de rotation qui limite la rotation relative du film magnétique fin (20) par rapport à la barre omnibus,
la partie de restriction de rotation comprenant une partie de restriction de position de montage qui limite une position de montage du film magnétique fin (20) sur la base (10) et la partie de restriction de rotation comprenant une partie de fixation de base qui limite la rotation relative de la base (10) par rapport à la barre omnibus.

2. Capteur de courant selon la revendication 1, dans lequel
la partie de restriction de position de montage a une partie de paroi qui entoure le film magnétique fin (20).

3. Capteur de courant selon la revendication 1, dans lequel
la partie de restriction de position de montage a un trou de logement sur lequel le film magnétique fin (20) est monté.

4. Capteur de courant selon la revendication 1, 2 ou 3, dans lequel
la partie de fixation de base a une broche de référence qui fait saillie de la base (10) vers la barre omnibus et qui est insérée dans un trou de référence formé dans la barre omnibus.

5. Capteur de courant selon l'une quelconque des revendications 1 à 4, comprenant en outre :
un élément de restriction (36) qui limite un angle d'un passage de lumière incidente, rayonnée sur le film magnétique fin (20), par rapport à une surface du film magnétique fin (20) et un angle d'un passage de lumière réfléchie, réfléchie à partir du film magnétique fin (20), par rapport à la surface du film magnétique fin (20).
